# EUROPEAN PATENT SPECIFICATION

(11) **EP 1 445 998 B1**
(45) Date of publication and mention of the grant of the patent: **24.10.2007**
(21) Application number: 03388024.6
(22) Date of filing: 25.04.2003
(51) Int. Cl.: H05K 9/00

(54) **A shield can for shielding electronic components on a PWB**
Abschirmdeckel zur Abschirmung von elektronischen Bauteilen auf einer Leiterplatte
Boîtier de blindage pour la protection de composants éléctroniques montés sur une carte de circuit imprimé

(30) Priority: 07.02.2003 EP 03388007
(43) Date of publication of application: 11.08.2004
(73) Proprietor: Sony Ericsson Mobile Communications AB, 221 88 Lund (SE)
(72) Inventor: Fagrenius, Gustav, 224 68 Lund (SE); Bengtsson, Henrik, 224 65 Lund (SE); Sandevi, Tommy, 211 26 Malmö (SE); Hermann, Frederik Per, 217 54 Malmö (SE); Andersson, Niklas, 226 44 Lund (SE); Meynert, Hans, 234 43 Lomma (SE)
(74) Representative: Andersen, Poul Hoeg

(56) References cited:
- WO-A-02/052916
- US-A- 5 566 055
- US-A- 5 608 188
- US-A- 5 811 050
- US-A- 6 051 780

## Description

### Technical field

The invention relates to a shield can for shielding electronic components on a PWB (printed wired board) in an electronic device which shield can is divided into sections which are linked together in a flexible manner.

### Related prior art

In order to shield electronic components on a PWB (printed wired board) in electronic devices against electro-magnetic radiation, a shielding in the form of an electrically conductive shield can or box is conventionally placed on the PWB covering the electronic components. The highest level of shielding is achieved when a closed metal can with a free rim at downwardly extending side walls is soldered to the PWB along the entire free edge of the metal can. A critical requirement that must be fulfilled in order to achieve good shielding is that the solder joint between the shield can and the PWB is well controlled, preferably without leaving any unsoldered areas. If any areas remain unsoldered the shielding efficiency is determined by the largest gap between the shield can and the PWB. Therefore, if gaps exist between the shield can and the PWB the sizes of these must be well defined.

The preferred method today for mounting electronic components to the PWB is to use the so-called surface mount technology (SMT) with a re-flow soldering method. In this method a solder paste is used which is a substance with cream-like consistency made up of solder, flux and a carrying medium. The mixture of solder and flux is 85%-95% solder and 5%-15% flux, where the solder consists of small particles shaped as balls and needles. There are high quality demands on the solder paste, when used in the electronic industry. The solder paste should e.g. nearby pads on the PWB, be sticky to hold the components during assembly and not get stuck in the holes of the screen-printing stencil, when such a stencil is used for applying the solder paste.

The first step in a soldering process is to apply the solder paste to pads on the PWB. This can be done by several methods including:
- Dispense solder paste through the end of a tube.
   This method is very similar to using a syringe. The solder paste is slightly pressurised and is dispensed through the end of a tube. Advantages of this method are for example that it allows little opportunity for solder contamination, since it employs a closed container for the solder paste. Other advantages include that the tube can reach into odd shaped places and that it is a relatively inexpensive method. Disadvantages of this method include that it is very difficult to apply the precise amount of solder paste to the PWB and that it is a relatively slow method.
- Dip dull pins into the solder paste.
   When using this method, dull pins are dipped into solder paste and the ends of the pins are then dabbed onto the PWB. The amount of solder paste is directly proportional to the size and shape of the pins. An advantage of this method is that it is fast, since it is possible to lower a whole array of pins onto the board at the same time.
- Screen-printing.
   Screen-printing is a method that yields an excellent result when applying solder paste, since it gives an exact and predetermined thickness of the layer of solder paste. A screen-printing stencil is made by a fine mesh of polyester or metal. The screen-printing stencil is placed slightly above the PWB and a squeegee is drawn over the stencil with a pressure that forces the solder paste through the stencil onto the PWB. The squeegee could be made of metal or rubber. If it is made of rubber, it is possible to put different amounts of solder paste on different places on the PWB. However, it has to be sharpened quite often.
- Stencil-printing.
   This method is very similar to screen-printing. The difference is that the stencil is not elastic and therefore the stencil is placed in contact with the PWB. Stencil-printing is mostly used for fine-pitch devices. This is a method that is perfectly suitable for high-volume production.

The preferred method for applying the solder paste to the PWB is the screen printing method described above. The PWB is screen-printed with solder paste at the desired areas where electronic components and the shield can(s) are to be mounted. The thickness of the solder paste is determined by the thickness of the screen-printing stencil and is the same all over the PWB.

The next step is to place the electronic components on the PWB by a pick-and-place machine. The shield can(s) is (are) normally placed on the PWB after the other components have been placed since shield cans must cover one or more of them. In the last step of the process the PWB is heated in a soldering oven, whereby the applied solder paste melts and all the components and the shield can(s) become soldered to the PWB.

When the PWB, together with the components, travels through the oven to melt the solder paste, the temperature follows a predetermined pattern. The oven is first heated to a temperature where the flux in the solder paste becomes active and the temperature is held for a period of time that is long enough to let the flux clean the base metal. After this, the temperature is raised above the melting temperature of the solder paste. The temperature is usually held at this level for 30 to 60 seconds, long enough to let the solder wet the PWB and the components. The last step is cooling the PWB, which is done at a continuous rate. There is a trade off in the cooling process. If the PWB is cooled quickly, the solder bonds will be strong, but it will introduce stresses in the PWB. Therefore, the cooling process must be controlled for ensuring a relatively strong bond without introducing too high stresses in the PWB.

Since small components, such as resistors and capacitors, need small volumes of solder paste and large components, such as shield cans, need large volumes of solder pate, the thickness of the screen-printing stencil has to be set as a compromise between these two different needs. Electronic components are constantly getting smaller in order to save space on the PWB, and smaller electronic components must have less solder paste in order to get soldered properly. Thinner screen-printing stencils will therefore be used in the future.

However, neither the shield cans nor the PWBs can be manufactured perfectly flat and, furthermore, the non-planarity of especially the PWB may be affected by the heat in the soldering oven. This means that there will always be a gap between the shield can and the PWB, which, however, is not a problem as long as the gap is filled with solder during heating. As described above the thickness of the solder paste initially applied to the PWB is limited and may in the future be decreased even further. This means that the acceptable size of the gap is also limited, if it must be ensured that the gap becomes filled with solder during the heating process. Furthermore, the size of the gap between the shield can and the PWB increases with the size of the shield can, and the size of the shield can must therefore be limited in order to ensure that the gap can be filled with the pre-applied solder paste.

In modern electronic devices that tend to be increasingly smaller it is desirable to combine several small shield cans into one large shield can with internal walls, since this will save space on the PWB. Fewer shield cans also result in faster assembling and a reduction in the manufacturing costs. Larger shield cans will, however, increase the risk for unsoldered gaps between the shield can and the PWB due to a non-planar PWB and/or a non-planar shield can.

An attempt to overcome this problem has been to dispense an extra thick layer of solder paste to the area of the PWB where the shield can is to be positioned. However, this calls for an undesired extra manufacturing step.

A type of shielding unit which has also been used in the industry is disclosed in US 6,051,780. This type of shielding unit is formed with portions of shielding unit being elastically deformable in the direction of the unit. The elastically deformable portions are formed by weakened areas in the material of the shielding unit.

### Object of the invention

It is an object of the invention to provide a shield can for shielding electronic components on a PWB with which the risk of unacceptable gaps between the mounted shield can and the PWB is eliminated.

### Summary of the invention

The object of the invention is achieved in that the sections of the shield are interconnected by flexible elements made of a flexible material, fastened to the edges of the sections. This will ensure flexibility between the sections such that any non-planarity of a PWB can be compensated for.

It is thereby also achieved that the individual sections of the shield can are able to flex in relation to each other such that the shield can is able to follow any non-planarity of a PWB on which the shield can is mounted. In this manner any non-planarity of the PWB that occurs by bending of a PWB can be compensated for. Thereby a secure and sufficiently close connection between the PWB and the shield can is ensured to achieve the desired shielding effect.

In one embodiment each section of the shield can comprises an upper cover part and downwardly extending side walls. Thereby each section serves as an individual shield can. However, since more of these individual shield cans are assembled to form one large shield can, the handling thereof is facilitated.

In another embodiment the shield can comprises a common upper cover part and downwardly extending side walls, where the upper cover part is divided into sections that are linked together, while the side walls are unconnected. This shield can operates like one large shield can that can flex in order to compensate for any non-planarity of a PWB.

The upper cover part may be made in one piece provided with a reduced material thickness between the sections. Thereby the flexible interconnections between the sections are achieved without use of other materials or elements than the one forming the shield can.

Alternatively, the sections of the upper cover part are interconnected by flexible elements made of a flexible material, such as rubber.

In a certain embodiment the dimensions of each section of the shield can constitute an integer number of a module measure. It is thereby possible to form any desired shield can by combining a number of such modularised sections. This leads to a decrease in production costs, since only a relatively small number of modularised sections that can be combined in numerous ways are needed.

It shall be emphasised that the term "comprise/comprising" when used in this specification is taken to specify the presence of stated features, integers, steps or components, but does not preclude the presence or addition of one or more other features, integers, steps, components or groups thereof.

### Description of the drawings

The invention will be described in detail in the following with reference to the drawings in which
Fig 1a and 1b illustrate the problems associated with the prior art shield cans;
Fig. 2 shows a first embodiment of a shield can according to the invention;
Fig. 3 shows the shield can shown in Fig. 2 mounted on a PWB;
Fig. 4 shows another embodiment of a shield can according to the invention;
Fig. 5 shows the shield can shown in Fig. 4 mounted on a PWB;
Fig. 6 shows yet another embodiment of a shield can according to the invention; and
Fig. 7 shows the shield can shown in Fig. 6 mounted on a PWB.

### Detailed description of an embodiment of the invention

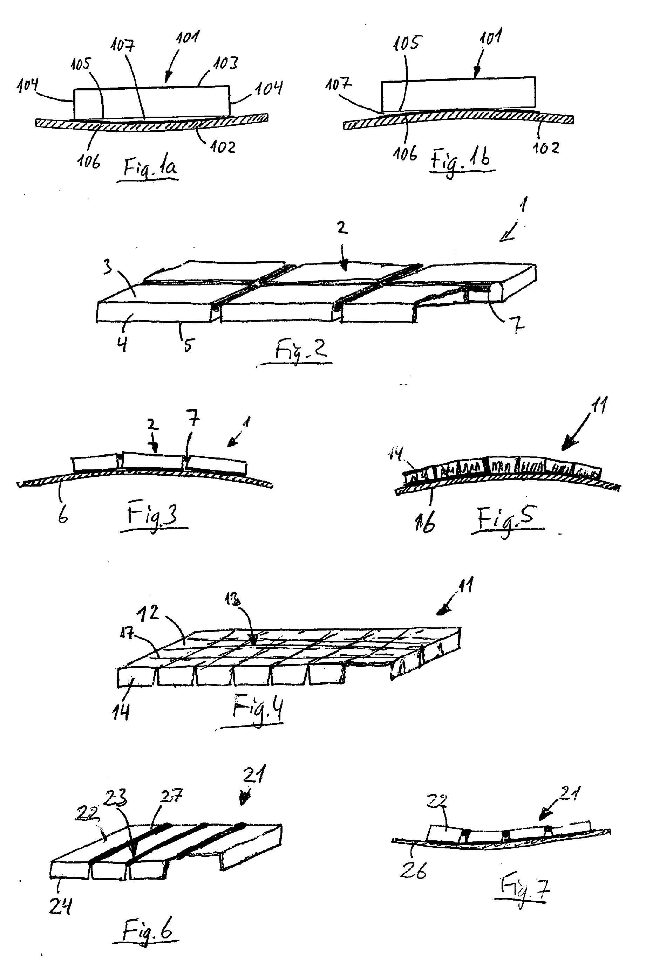

Figs 1a and 1b show cross-sections taken through a shield can 101 and a PWB 102 and illustrate the problems associated with the prior art method for mounting a shield can 101 on a PWB 102. In the embodiment shown, the shield can 101 is box-shaped and consists of a metal shell forming a flat upper cover part 103 and four downwardly extending side walls 104 with a free rim 105. As described above PWBs 102 are never totally planar due to internal stresses in the PWB 102 occasioned by the manufacturing process. Figs 1a and 1b each shows a PWB 102 that bends downwards and upwards, respectively. In order to better illustrate the problems associated with the prior art mounting of a shield can 101 on a PWB 102 the bending of the PWBs 102 as shown in Figs 1a and 1b is exaggerated. Furthermore, for clarity reasons no other components than the shield can 101 is shown; in practice the electronic components to be shielded are positioned on the PWB 102 within the mounted shield can 101. In Figs 1a and 1b the PWB 102 is provided with a pre-applied thin layer of solder paste 106 provided at the area where the rim 105 of the shield can 101 is intended to be connected to the PWB 102 by heating of the pre-applied solder paste 106.

In Fig. 1a the PWB 102 bends downwards, and due to this downwards bending a gap 107 exists between the PWB 102 and the rim 105 of the shield can 101. It is not possible to close the gap 107 with the pre-applied solder paste 106, and if the PWB 102 bends as much as shown in Fig. 1a the gap 107 extends from one side of the shield can 101 to the other. Thereby the shielding efficiency is substantially reduced.

In the situation shown in Fig. 1b the PWB 102 bends upwards and the rim 105 of the shield can 101 is connected to the PWB 102 at a very limited area only. In this instance the gap 107, which is not closed by the pre-applied solder paste 106, between the PWB 102 and the rim 105 of the shield can 101 extends over more than two sides of the shield can 101. Again the shielding efficiency of the shield can 101 is substantially reduced.

In practice, the PWB 102 bends less than shown in Figs 1a and 1b and the gap 107 is smaller than shown. However, since the degree of bending of the PWB 102 - and of the shield can 101 as well - is to some degree unpredictable, there is always a risk that a gap 107 of an unpredictable size occurs, thereby reducing the shielding efficiency.

Fig. 2 shows a first embodiment of a shield can 1 according to the invention. The shield can 1 is divided into six identical sections 2 that each serves as a separate shield can. That each section 2 defines a separate shield can is clearly illustrated by the foremost right section 2 that is shown partly in cross-section.

In this embodiment each section 2 is provided with an upper cover part 3 and downwardly extending side walls 4. The lower end of the side walls 4 has a rim 5 that is adapted to be soldered to a PWB 6 as shown in Fig. 3.

A flexible connecting element 7 made of a flexible material is provided between the sections 2 of the shield can 1 and fastened to the edges of the sections 2. Thereby, the sections 2 are able to flex in relation to each other which means that any non-planarity of the PWB 6 can be compensated for by the shield can 1 by flexing between the sections 2 thereof. The flexible elements 7 are preferably made of a rubber-like material that is fastened to the side walls 4 of the sections 2, e.g. by gluing.

Fig. 3 shows the shield can 1 mounted on a PWB 6 that bends upwards. In relation to real situations the degree of bending is largely exaggerated in order to better show the gist of the invention. It is clearly shown how the sections 2 of the shield can 1 flex in relation to each other by means of the flexible elements 7 and thereby compensate for the bending of the PWB 6 without leaving any unsoldered areas between the PWB 6 and the shield can 1.

Since the shield can 1 is divided into sections 2 that each serves as a separate shield can the PWB 6 must be designed to receive such a shield can 1, i.e. the PWB 6 must be sectionalised with solder paste being applied in a suitable pattern corresponding to the rim 5 of each section 2.

In one embodiment the dimensions of each section 2 of the shield can 1 constitute an integer number of a module measure that is to be construed as e.g. the width of one section 2. By dimensioning each section 2 in accordance with such a module measure differently shaped sections can be assembled to form the shield can (not shown).

Fig. 4 shows another embodiment for a shield can 11 according to the invention. This shield can 11 is also divided into sections 12 that are interconnected to form the shield can 11. In this embodiment the shield can 11 is made in one piece that is provided with a reduced material thickness between the sections 12; the area with a reduced material thickness forming bending lines 17 on the surface of the upper cover part. The shield can 11 is provided with a common upper cover part and downwardly extending side walls 14 at the outer circumference of the cover part. In this embodiment no internal walls are provided as indicated by the cut-away area at the foremost right corner of the shield can 11. The side walls 14 are unconnected in order to allow a mutual flexing between the sections 12 when the shield can 11 is mounted on a bended PWB 16 as shown in Fig. 5.

The bending lines 17 of reduced material thickness between the sections 12 of the shield can 11 are shown as forming a substantially square pattern on the upper cover part. Thereby the shield can 11 is able to compensate for bending of a PWB 16 in two directions. Of course, the bending lines 17 could form other patterns, such as e.g. parallel lines only if bending in one direction only is to be compensated for.

Fig. 6 shows partly in cross-section yet another embodiment for a shield can 21 according to the invention. Again, the shield can 21 is divided into sections 22 that in this embodiment form transversal strips that are interconnected by flexible elements 27 connected to the edges of the sections 22. Thereby the shield can 21 is able to compensate for the bending of a PWB 26 as shown in Fig. 7 which shows a downwardly bending PWB 26 provided with the shield can 21. This shield can also comprises a common upper cover without any internal walls.

The invention has been described with reference to different embodiments employing a generally box-shaped shield can. However, the shield can need not be box-shaped; it may also be dome-shaped or shaped as any other hollow, three-dimensional member provided with a downwardly extending rim. The shield can may also be provided with internal walls that extend from the upper cover part of the shield can to the PWB for dividing the shield can into any desired closed volumes.

When choosing the material of the shield can, there is a wide selection of different materials to choose from. Different types of plastic materials and metal alloys with varying shielding characteristics are used on the market. Metal cans are mainly used for non-complicated geometries and are relatively inexpensive. The possibilities to create more complicated geometries increase when a plastic material is used, but these types of shield cans are often more expensive to produce. In order to obtain sufficient shielding effectiveness, the plastic material must be conductive and this is achieved by e.g. spraying it with conductive paint.

The flexible interconnection between the sections of the shield can may also be varied from the ones described. For instance, if a flexible rubber material is employed this may advantageously be electrically conductive. The interconnections may also be in the form of hinges provided between the sections.

## Claims

1. A shield can (1;21) for shielding electronic components on a PWB (printed wired board) (6;26) in an electronic device, which shield can (1;21) is divided into sections (2;22) that are linked together in a flexible manner, **characterised in that** the sections (2;22) of the shield can (1;21) are interconnected by flexible elements (7;27) made of a flexible material, fastened to the edges of the sections (2;22).

2. A shield can according to claim 1, **characterised in that** each section (2;22) of the shield can (1;21) comprises an upper cover part (3;23) and downwardly extending side walls (4;24).

3. A shield can (11;21) for shielding electronic components on a PWB (printed wired board) (16; 26) in an electronic device, which shield can (11;21) is divided into sections (12;22) that are linked together in a flexible manner, **characterised in that** the shield can (11;21) comprises a common upper cover part (13;23) and downwardly extending side walls (14;24), the upper cover part (13;23) being divided into sections (12;22) that are linked together, while the side walls (14;24) are unconnected.

4. A shield can according to claim 3, **characterised in that** the upper cover part (13) is made in one piece provided with a reduced material thickness between the sections (12).

5. A shield can according to claim 3, **characterised in that** the sections (22) of the upper cover part (23) are interconnected by flexible elements (27) made of a flexible material, such as rubber.

6. A shield can according to any one of claims 1-5, **characterised in that** the dimensions of each section (2;12;22) of the shield can (1;11;21) constitute an integer number of a module measure.

## Patentansprüche

1. Abschirmungsgehäuse (1; 21) zum Abschirmen elektronischer Komponenten auf einem PWB (printed wired board) (6; 26) in einer elektronischen Vorrichtung, wobei das Abschirmungsgehäuse (1; 21) in Abschnitte (2; 22) unterteilt ist, die auf eine flexible Weise miteinander verbunden sind, **dadurch gekennzeichnet, dass** die Abschnitte (2; 22) des Abschirmungsgehäuses (1; 21) untereinander durch aus einem flexiblen Material gefertigte flexible Elemente (7; 27) verbunden sind, die an den Kanten der Abschnitte (2; 22) befestigt sind.

2. Abschirmungsgehäuse nach Anspruch 1, **dadurch gekennzeichnet, dass** jeder Abschnitt (2; 22) des Abschirmungsgehäuses (1; 21) einen oberen Abdeckbereich (3; 23) und sich nach unten erstreckende Seitenwände (4; 24) umfasst.

3. Abschirmungsgehäuse (11; 21) zum Abschirmen elektronischer Komponenten auf einem PWB (printed wired board) (16; 26) in einer elektronischen Vorrichtung, wobei das Abschirmungsgehäuse (11; 21) in Abschnitte (12; 22) unterteilt ist, die auf eine flexible Weise miteinander verbunden sind, **dadurch gekennzeichnet, dass** das Abschirmungsgehäuse (11; 21) einen gemeinsamen oberen Abdeckbereich (13; 23) und sich nach unten erstreckende Seitenwände (14; 24) umfasst, wobei der obere Abdeckbereich (13; 23) in Abschnitte (12; 22) unterteilt ist, die miteinander verbunden sind, wobei die Seitenwände (14; 24) getrennt sind.

4. Abschirmungsgehäuse nach Anspruch 3, **dadurch gekennzeichnet, dass** der obere Abdeckbereich (13) aus einem Stück gefertigt ist, das mit einer verminderten Materialdicke zwischen den Abschnitten (12) vorgesehen ist.

5. Abschirmungsgehäuse nach Anspruch 3, **dadurch gekennzeichnet, dass** die Abschnitte (22) des oberen Abdeckbereichs (23) untereinander durch flexible Elemente (27) verbunden sind, die aus einem flexiblen Material, wie beispielsweise Gummi, gefertigt sind.

6. Abschirmungsgehäuse nach einem der Ansprüche 1 bis 5, **dadurch gekennzeichnet, dass** die Ausmaße jedes Abschnitts (2; 12; 22) des Abschirmungsgehäuses (1; 11; 21) eine ganze Zahl eines Modulmaßes bilden.

## Revendications

1. Boîtier métallique de blindage (1 ; 21) prévu pour protéger des composants électroniques montés sur une carte à circuit imprimé (PWB) (6 ; 26) dans un dispositif électronique, lequel boîtier de blindage (1 ; 21) est divisé en sections (2 ; 22) qui sont reliées entre elles de façon articulée et de manière flexible, **caractérisé en ce que** les sections (2 ; 22) du boîtier de blindage (1 ; 21) sont reliées entre elles par des éléments flexibles (7 ; 27) faits en une matière flexible, et fixés sur les bords des sections (2 ; 22).

2. Boîtier métallique de blindage selon la revendication 1, **caractérisé en ce que** chaque section (2 ; 22) du boîtier de blindage (1 ; 21) comprend une partie formant couvercle supérieur (3; 23) et des parois latérales s'étendant vers le bas (4 ; 24).

3. Boîtier métallique de blindage (11 ; 21) prévu pour protéger des composants électroniques montés sur une carte à circuit imprimé (PWB) (16 ; 26) dans un dispositif électronique, lequel boîtier de blindage (11 ; 21) est divisé en sections (12 ; 22) qui sont reliées entre elles de façon articulée et de manière flexible, **caractérisé en ce que** le boîtier de blindage (11 ; 21) comprend une partie formant couvercle supérieur commun (13 ; 23) et des parois latérales s'étendant vers le bas (14 ; 24), la partie formant couvercle supérieur (13 ; 23) étant divisée en sections (12 ; 22) qui sont reliées entre elles de façon articulée, tandis que les parois latérales (14 ; 24) sont non reliées.

4. Boîtier métallique de blindage selon la revendication 3, **caractérisé en ce que** la partie formant couvercle supérieur (13) est faite d'une seule pièce, avec une épaisseur réduite de matière entre les sections (12).

5. Boîtier métallique de blindage selon la revendication 3, **caractérisé en ce que** les sections (22) de la partie formant couvercle supérieur (23) sont reliées entre elles par des éléments flexibles (27) faits en une matière flexible, telle que du caoutchouc.

6. Boîtier métallique de blindage selon l'une quelconque des revendications 1 à 5, **caractérisé en ce que** les dimensions de chaque section (2 ; 12 ; 22) du boîtier de blindage (1 ; 11 ; 21) constituent un nombre entier d'une mesure de module.
